# EUROPEAN PATENT APPLICATION

(11) **EP 4 607 397 A1**
(43) Date of publication of application: **27.08.2025**
(21) Application number: 24159061.1
(22) Date of filing: 22.02.2024
(51) Int. Cl.: G06F 30/20

(54) **COMPUTER-IMPLEMENTED METHOD AND SYSTEM FOR OBTAINING SIMULATION PARAMETERS**

(71) Applicant: Siemens Aktiengesellschaft, 80333 München (DE)
(72) Inventor: Heinrich, Christoph, 86609 Donauwörth (DE); Loukrezis, Dimitrios, 80809 München (DE); Manvelyan, Diana, 80687 München (DE); Söllner, Uliana, 81825 München (DE)
(74) Representative: Siemens Patent Attorneys

(57) **Abstract**

The invention relates to a computer-implemented method for retrieving simulation parameters for executing a first simulation model that is configured to control a technical system, comprising the method steps:
• transmitting (S1) first metadata (MD1) of the first simulation model (SIM1) to an analysis unit,
• providing (S2) a variety of metadata (MD2, ..., MDn), each associated with a simulation model (SIM2, ..., SIMn), wherein simulation parameters (SP2, ..., SPn) for executing the respective simulation model are assigned to each metadata, and wherein the variety of metadata and corresponding simulation parameters are stored in a database (102),
• deriving (S3) a similarity score (SC) for the first metadata by comparing the first metadata (MD1) with second metadata (MD2), wherein the second metadata (MD2) are selected from the variety of metadata (MD2, ..., MDn), and
• providing (S4) the simulation parameters (SP2) associated with the second metadata together with the similarity score.

## Description

The present invention relates to a computer-implemented method and system for retrieving simulation parameters for executing a simulation model that is configured to control a technical system.

Non-linear calculations or computer simulations with corresponding tools require solver parameters to be set for a converged solution or to speed up convergence. These can be the correct and physical settings of boundary conditions or parameters in the non-linear solver itself (e.g., Newton iteration). It still can happen that algorithms diverge during the solution process after longer time periods of hours or days, wasting time and/or computing resources.

Usually suitable solver/simulation parameters are set individually by each simulation engineer based on his/her experience. Sometimes parameters and their effect are not made transparent. In addition, a parameter set cannot lead to a convergent solution for the same problem (or input deck) and software after a version change of the simulation software. Then, the only way is a manual or automatic trial and error procedure requiring a lot of time, which can lead to a severe financial risk.

It is therefore an objective of the present invention to easily obtain suitable simulation parameters for executing a computer simulation.

The object is solved by the features of the independent claims. The dependent claims contain further developments of the invention.

The invention provides according to the first aspect a computer-implemented method for obtaining simulation parameters for executing a first simulation model that is configured to control a technical system, comprising the method steps:
- transmitting first metadata of the first simulation model to an analysis unit,
- providing a variety of metadata, each associated with a simulation model, wherein simulation parameters for executing the respective simulation model are assigned to each metadata, and wherein the variety of metadata and corresponding simulation parameters are stored in a database,
- deriving a similarity score for the first metadata by comparing the first metadata with second metadata, wherein the second metadata are selected from the variety of metadata,
   and
- providing the simulation parameters associated with the second metadata together with the similarity score.

It is an advantage of the present invention that simulation parameters for a simulation model - also further specified as solver parameters or simulation parameters - can be retrieved based on simulation metadata without the need of disclosing all details about the simulation model. This leads to simulation parameter proposals that are suitable for a given simulation model, based on respective metadata. The proposed method and system help to speed up the process of finding suitable solver parameters. Time consuming parameter searches and/or divergent simulation runs can therefore be reduced. In addition, the simulation parameter proposal is anonymized as it is based only on simulation metadata. This enables for example also an exchange of simulation parameters among different users, e.g., a cross-company approach.

According to a preferred embodiment the method may further comprise the following steps:
- executing the first simulation model using the simulation parameters assigned to the second metadata and returning a convergence result,
   and
- storing the first metadata, the simulation parameter associated with the second metadata, and the convergence result in the database.

By executing the first simulation model using solver parameters that were successfully used for another preferably similar simulation model, the convergence of the first simulation model can be checked and feedback on the proposed simulation parameters can be returned.

According to a further embodiment the metadata of a simulation model may comprise:
- information about the technical system to be simulated,
- physics that are modelled by the simulation model,
- geometry of the simulation model,
- time integration method used by the simulation model,
- mesh element type of the simulation model,
- mesh refinement of the simulation model,
- time grid refinement of the simulation model,
- a stability label of the simulation model,
- Reynolds numbers of the simulation model,
- under-relaxation factors of the simulation model,
   and/or,
- mesh quality index of the simulation model.

The metadata therefore can characterize the simulation model but preferably do not reveal details that are worth protecting.

According to a further embodiment the similarity score is derived using a machine-learning method.

According to a further embodiment the transmission of the first metadata to the analysis unit, the retrieval of simulation parameters from the database, and/or the storage in the database of the first metadata, the simulation parameters, and the convergence result, can be cryptographically encrypted.

This ensures further data protection. Preferably an asymmetric encryption can be used.

According to a further embodiment the technical system is controlled based on the executed first simulation model using the simulation parameters assigned to the second metadata.

According to a further embodiment the variety of metadata, each associated with a simulation model, can be provided by different users.

As the metadata provide information about the simulation model in an anonymized way the exchange of metadata as well as associated simulation parameters among different users - also without mutual trust - is possible.

According to a further embodiment the provision of metadata and assigned simulation parameters can be assessed by an assessment unit and assessment points are returned.

In that way it is possible to also set up a remuneration or credit system for users which provide metadata and assigned simulation parameters.

The invention further provides according to the second aspect a system for obtaining simulation parameters for executing a first simulation model that is configured to control a technical system, the apparatus comprising:
- an interface that is configured to transmit first metadata of the first simulation model to an analysis unit,
- a database that is configured to provide a variety of metadata, each associated with a simulation model, wherein simulation parameters for executing the respective simulation model are assigned to each metadata, and wherein the variety of metadata and corresponding simulation parameters are stored in the database,

- the analysis unit that is configured to derive a similarity score for the first metadata by comparing the first metadata with second metadata, wherein the second metadata is selected from the variety of metadata,
   and,
- an output unit that is configured to provide the simulation parameters associated with the second metadata together with the similarity score.

According to an embodiment the system can further comprise a simulation unit that is configured to execute the first simulation model using the simulation parameters assigned to the second metadata and returning a convergence result, and wherein the database is further configured to store the first metadata, the simulation parameter associated with the second metadata, and the convergence result.

According to an embodiment the system can further comprise assessment unit that is configured to assess the provision of metadata and assigned simulation parameters and to return assessment points.

In addition, a computer program product (non-transitory computer readable storage medium having instructions, which when executed by a processor, performs actions) having program instructions for performing the aforementioned method according to embodiments of the invention is claimed.

The invention will be explained in more detail by reference to the accompanying figures.
- Fig. 1:: an exemplary embodiment of a computer-implemented method for obtaining simulation parameters for executing a simulation model; and
- Fig. 2:: an exemplary embodiment of a system for obtaining simulation parameters for executing a first simulation model.

Equivalent parts in the different figures are labeled with the same reference signs.

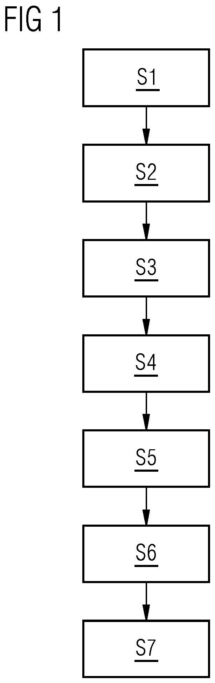

Figure 1 shows an exemplary embodiment of a computer-implemented method for obtaining simulation parameters for executing a first simulation model. The first simulation model is configured to control a technical system.

The technical system can be for example a technical device/instrument, a robot, a machine tool, industrial plant, a power plant, a motor, a turbine, or an engine, etc., but is not limited to such examples. The technical system can be controlled using the simulation model. To this end, the execution of the simulation model provides control parameters for controlling the technical system, as the physical simulation model of the technical system comprises physical properties of the technical system and can be used to perform a physical simulation, e.g. a dynamical simulation, of its performance.

The computer-implemented method comprises the following method steps:
In a first step, the first metadata of the first simulation model are provided. Depending on the type of the computer simulation or the type of technical system that can be simulated, the metadata can comprise the following information:
- information about the technical system to be simulated,
- physics that are modelled by the simulation model,
- geometry of the simulation model,
- time integration method used by the simulation model,
- mesh element type of the simulation model,
- mesh refinement of the simulation model,
- time grid refinement of the simulation model,
- a stability label of the simulation model,
- Reynolds numbers of the simulation model,
- under-relaxation factors of the simulation model,
   and/or
- mesh quality index of the simulation model.

The metadata therefore provide information on the simulation model in an anonymized way. For example, a first user provides the first metadata.

The first metadata are transmitted to an analysis unit. For example, the first user requests simulation parameters for executing the first simulation. To this end, the first user provides the first metadata to the analysis unit.

In the next step S2 a variety of metadata is provided, each associated with a simulation model. Furthermore, simulation parameters that are suitable for executing the respective simulation models are assigned to each metadata. The variety of metadata and corresponding simulation parameters are stored in the database. Preferably, the respective simulation models are not stored in the database.

In the next step S3 second metadata are selected from the variety of metadata stored in the database. Then, a similarity score for the first metadata by comparing the first metadata with second metadata is computed. The similarity score can be given in percentage. Preferably, the similarity score is derived by applying a machine-learning-method, e.g., regression.

In the next step S4 the simulation parameters associated with the second metadata are provided together with the similarity score. Preferably, the simulation parameters associated with the second metadata are provided depending on the similarity score, i.e., for example based on a given criteria or threshold, e.g., the simulation parameters are only provided if the similarity score meets the criteria or threshold.

In the next step S5 the first simulation model can be executed using the simulation parameters assigned to the second metadata and a convergence result, e.g., "simulation converged/diverged", is returned.

In a next step S6 the first metadata, the simulation parameters, and the convergence result can be stored in the database, preferably, only if the simulation converged. After execution of the simulation model, this feedback comprising the first metadata, the used simulation parameters (i.e., the simulation parameters assigned to the second metadata), and the convergence result, is returned and can be stored as a dataset in the database. In that way, this information can be used for a subsequent simulation parameter retrieval based on simulation metadata.

In the next step S7, based on the executed first simulation model by using the simulation parameters assigned to the second metadata, the technical system can be controlled using the output of the first simulation.

Preferably, the transmission of the first metadata to the analysis unit, the provision of simulation parameters from the database, and/or the storage in the database of the first metadata, the simulation parameters, and the convergence result, can be cryptographically encrypted.

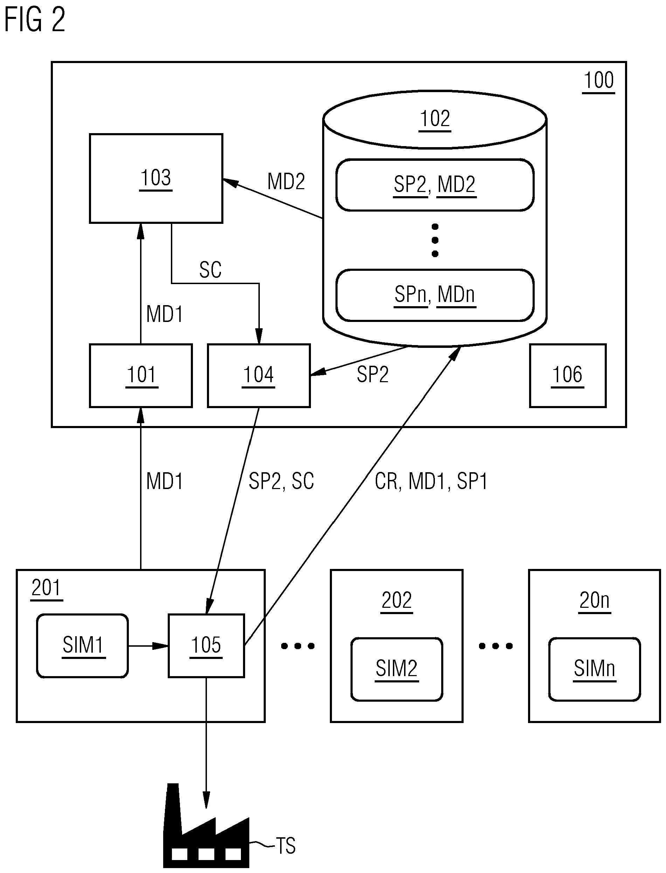

Figure 2 shows an embodiment of a system for obtaining simulation parameters for executing a first simulation model that is configured to control a technical system, e.g., a production plant. In order to control the technical system, with the simulation model the production plant can be simulated and the simulation model outputs for example optimized control parameters for controlling the technical system. Therefore, suitable simulation parameters are required for executing the first simulation model.

The system 100 that is configured to provide the simulation parameters comprises the following elements: an interface 101, a database 102, an analysis unit 103, and an output unit 104. Furthermore, the system can comprise at least one processor, as well as a simulation unit 105, and/or an assessment unit 106.

The system 100 can be used by different users 201, 202, ..., 20n, for example different companies. Each user 201, 202, ..., 20n can provide a simulation model SIM1, SIM2, ..., SIMn, wherein the simulation models can be similar or differ from another.

Each simulation model SIM1, SIM2, ..., SIMn, can be characterized by simulation metadata MD1, MD2, ..., MDn. Metadata can be extracted from the simulation model.

Metadata MD1, MD2, ..., MDn of simulation models SIM1, SIM2, ..., SIMn can comprise the following information:
- information about the technical system to be simulated,
- physics that are modelled by the simulation model,
- geometry of the simulation model,
- time integration method used by the simulation model,
- mesh element type of the simulation model,
- mesh refinement of the simulation model,
- time grid refinement of the simulation model,
- a stability label of the simulation model,
- Reynolds numbers of the simulation model,
- under-relaxation factors of the simulation model,
   and/or
- mesh quality index of the simulation model.
Therefore, in order to find a similar simulation model, respective metadata can be compared.

A first user 201 can send a request to the system 100 for obtaining suitable simulation parameters for executing a first simulation model for controlling the production plant TS. The request can be cryptographically protected. To this end, the user 201 provides metadata MD1 associated with the first simulation model SIM1. For example, the first metadata can at least comprise information about the production plant TS.

The database 102 is configured to provide a variety of metadata MD2, ..., MDn, each associated with a simulation model, wherein simulation parameters SP2, ..., SPn for executing the respective simulation model are assigned to each metadata, and wherein the variety of metadata and corresponding simulation parameters are stored in the database 102. Preferably, data pairs/datasets comprising metadata and corresponding simulation parameters are stored in the database 102.

The first metadata MD1 are transmitted by the transmitter 101 to the analysis unit 103. The analysis unit 103 is configured to derive a similarity score SC for the first metadata MD1 by comparing the first metadata MD1 with second metadata MD2, wherein the second metadata is selected from the variety of metadata MD2, ..., MDn. Preferably, a similarity score can be derived for each metadata of the variety of metadata MD2, ..., MDn. Then, preferably, the metadata MD2 having the highest similarity score can be selected.

The output unit 104 is configured to output the simulation parameters SP2 associated with the second metadata together with the similarity score SC and return both to the first user 201. Preferably, the output can be cryptographically encrypted.

The simulation unit 105 is configured to execute the first simulation model SIM1 using the simulation parameters SP2 assigned to the second metadata and returning a convergence result CR. Preferably, the simulation unit 105 is configured on the user side to ensure confidentiality. If the model converges, the simulation unit 105 provides for example as a simulation result control parameters for controlling the production plant TS. Then, the production plant TS can be controlled using these control parameters based on the first simulation model SIM1.

The first metadata MD1, the simulation parameter SP2 associated with the second metadata, and the convergence result CR can then be returned to and stored in the database 102. This dataset can be sent back to the database 102 in a cryptographically protected way.

The assessment unit 106 is configured to assess the provision of metadata and assigned simulation parameters and to return assessment points. For example, the assessment unit can provide assessment points for providing metadata and assigned simulation parameters, and/or the assessment points can be based on the convergence result. For example, a user 201, ..., 20n, can gain assessment points if the user provides metadata and simulation parameters to the database.

The system 100 can be further explained using the following example:
The system 100 can use knowledge about simulation model parameters within a company and across companies.

In the case of running within a company, the users 201, ..., 20n are local computers, e.g., of simulation engineers, with installed simulation software and network connection. In the case of a solution across companies, the users 201, ..., 20n are different companies or users of different companies.

Different simulation models SIM1, ..., SIMn, are set up in a design or pre-processing tools and simulation runs can be performed on local CPUs or in a cloud solution.

The system 100 can be a central simulation parameter data server comprising data storage 102 where simulation parameter SP2, ..., SPn sets are stored together with metadata MD2, ..., MDn, of simulation runs, an analysis unit 103 that is able to receive metadata and match it with already existing data from the database 102 leading to a similarity score SC. The similarity score is for example computed via a machine learning method, such as regression, based on the features contained in the respective metadata.

Furthermore, the system 100 can comprise the assessment unit 106, that can be implemented as a credit unit that is configured to evaluate a contribution of a company to the database and executes credit update or payment.

If a company 201 wants to perform a simulation analysis (e.g., CFD, structure,...) for a technical system using a simulation model set up in a design or preprocessing tool, an encrypted request with the metadata MD1 is sent to the system 100. The system 100 analyzes the metadata MD1 in the analysis unit 103 based on metadata from the database 102 and sends back a parameter set proposal SP2 for the simulation solver with a similarity score SC. The proposed parameter set SP2 is fed into the simulation model SIM1 and the simulation model SIM1 is executed. After the simulation run, feedback is sent back to the system 100 and stored in the database 102.

The company credit unit 106 evaluates new contribution to the database 102 and executes credit transfer. The credit system or points assessment unit is a means to make contributions to simulation parameter data exchange attractive for users to join the community.

Different assessment systems can be implemented and combined, for example:
- a user only receives simulation parameter when also sharing metadata and simulation parameters,
- based on the feedback metadata, a point score is computed and (credit) points depend on it, e.g., high quality data sets with fast convergence can lead to higher point scores.

Often companies are focusing on solving similar problems as their products and versions of their products are similar (e.g., turbine blades). In that case, the system 100 needs to make sure, first, to process data of a company separately such that the data is not shared with others and, second, that data from other companies are not used in the parameter recommendation. Here, cybersecurity aspects come into play as manipulated feedback on proposed data sets can sabotage new product developments. To increase the cybersecurity level, the system 100 could also be set up internally within a company.

All of the described and/or drawn features as shown by the embodiments can be advantageously combined within the scope of the invention.

Although the present invention has been described in detail with reference to the preferred embodiment, it is to be understood that the present invention is not limited by the disclosed examples, and that numerous additional modifications and variations could be made thereto by a person skilled in the art without departing from the scope of the invention.

## Claims

1. Computer-implemented method for obtaining simulation parameters for executing a first simulation model (SIM1) that is configured to control a technical system (TS), comprising the method steps:
• transmitting (S1) first metadata (MD1) of the first simulation model to an analysis unit (104),
• providing (S3) a variety of metadata (MD2, ..., MDn), each associated with a simulation model (SIM2, ..., SIMn), wherein simulation parameters (SP2, ..., SPn) for executing the respective simulation model are assigned to each metadata, and wherein the variety of metadata and corresponding simulation parameters are stored in a database (102),
• deriving (S4) a similarity score (SC) for the first metadata by comparing the first metadata (MD1) with second metadata (MD2), wherein the second metadata (MD2) are selected from the variety of metadata (MD2, ..., MDn),
and
• providing (S5) the simulation parameters (SP2) associated with the second metadata together with the similarity score (SC).

2. Computer-implemented method according to claim 1, further comprising the steps:
• executing (S6) the first simulation model (SIM1) using the simulation parameters (SP2) assigned to the second metadata and returning a convergence result (CR),
and
• storing (S7) the first metadata (MD1), the simulation parameter associated with the second metadata, and the convergence result (CR) in the database.

3. Computer-implemented method according to one of the preceding claims wherein the metadata (MD1, MD2, ..., MDn) of a simulation model (SIM1, SIM2, ..., SIMn) comprise:
• information about the technical system to be simulated,
• physics that are modelled by the simulation model,
• geometry of the simulation model,
• time integration method used by the simulation model,
• mesh element type of the simulation model,
• mesh refinement of the simulation model,
• time grid refinement of the simulation model,
• a stability label of the simulation model,
• Reynolds numbers of the simulation model,
• under-relaxation factors of the simulation model,
and/or
• mesh quality index of the simulation model.

4. Computer-implemented method according to one of the preceding claims wherein the similarity score (SC) is derived using a machine-learning method.

5. Computer-implemented method according to one of the preceding claims wherein
• the transmission of the first metadata to the analysis unit,
• the provision of simulation parameters from the database,
and/or
• the storage in the database of the first metadata, the simulation parameters, and the convergence result,
are cryptographically encrypted.

6. Computer-implemented method according to one of the preceding claims wherein the technical system (TS) is controlled (S8) based on the executed first simulation model (SIM1) using the simulation parameters (SP2) assigned to the second metadata.

7. Computer-implemented method according to one of the preceding claims wherein the variety of metadata, each associated with a simulation model, is provided by different users.

8. Computer-implemented method according to one of the preceding claims wherein the provision of metadata and assigned simulation parameters is assessed by an assessment unit and assessment points are returned.

9. System (100) for obtaining simulation parameters for executing a first simulation model that is configured to control a technical system, the apparatus comprising:
• an interface (101) that is configured to transmit first metadata of the first simulation model to an analysis unit (103),
• a database (102) that is configured to provide a variety of metadata, each associated with a simulation model, wherein simulation parameters for executing the respective simulation model are assigned to each metadata, and wherein the variety of metadata and corresponding simulation parameters are stored in the database,
• the analysis unit (103) that is configured to derive a similarity score for the first metadata by comparing the first metadata with second metadata, wherein the second metadata is selected from the variety of metadata,
and
• an output unit (104) that is configured to provide the simulation parameters (SP2) associated with the second metadata together with the similarity score (SC).

10. System (100) according to claim 9 further comprising a simulation unit (105) that is configured to execute the first simulation model (SIM1) using the simulation parameters (SP2) assigned to the second metadata and returning a convergence result (CR), and wherein the database is further configured to store the first metadata, the simulation parameter associated with the second metadata, and the convergence result (CR).

11. System according to claim 9 or 10 further comprising an assessment unit (106) that is configured to assess the provision of metadata and assigned simulation parameters and to return assessment points.

12. Computer program product directly loadable into the internal memory of a digital computer, comprising software code portions for performing the method steps of one of the claims 1 to 8 when said computer program product is run on the computer.
